# EUROPEAN PATENT APPLICATION

(11) **EP 3 089 574 A1**
(43) Date of publication of application: **02.11.2016**
(21) Application number: 16163162.7
(22) Date of filing: 31.03.2016
(51) Int. Cl.: H05K 13/08

(54) **METHOD FOR ANALYZING PERFORMANCE OF A PRODUCTION LINE AND ANALYSIS SYSTEM**

(30) Priority: 01.05.2015 NL 2014745
(71) Applicant: Korsmit Production Improvement, 4884 AK Wernhout (NL)
(72) Inventor: Korsmit, Udo Norbertus Cornelis Johanna, 4884 AK Wernhout (NL)
(74) Representative: 't Jong, Bastiaan Jacob

(57) **Abstract**

The invention relates to a method for analysing performance of a production line provided with a number of devices, including a first device and a second device placed downstream thereof, and provided with a SMEMA interface between the first device and the second device; with the steps of:
- (a) tapping available signals from the SMEMA interface using a tap module; and
- (b) receiving a pair of available signals from the tap module using an analyser, comprising an available signal from the first device and an available signal from the second device overlapping in time with the available signal from the first device.

**The method further has the steps of:**
- (c) measuring the time difference in duration of the pair of available signals using the analyser;
- (d) determining a source device corresponding to the final starting moment of the pair of available signals;
- (e) assigning the time difference to the source device using an assigning unit.

## Description

The invention relates to a method for analysing performance of a production line provided with a number of devices, including a first device and a second device placed downstream thereof, and provided with a SMEMA interface between the first device and the second device; with the steps of:
- (a) tapping available signals from the SMEMA interface using a tap module; and
- (b) receiving a pair of available signals from the tap module using an analyser, comprising an available signal from the first device and an available signal from the second device overlapping in time with the available signal from the first device.

The invention further relates to an analysis system for analyzing performance of a production line provided with a number of devices, including a first device and a second device placed downstream thereof, and provided with a SMEMA interface between the first device and the second device, wherein the analysis system is provided with:
- a tap module for tapping available signals from the SMEMA interface;
- an analyser for receiving a pair of available signals, comprising an available signal from the first device and an available signal from the second device overlapping in time with the available signal from the first device.

US2003135296A1 describes a production line of machines configured to equip substrates with components. In the production line SMEMA interfaces between every two adjoining devices are intervened in by SMEMA emulators. These emulators forward the signals on this SMEMA interface to a coordination system and thereby form a monitoring system. The coordination system thus for instance receives a SMEMA signal from one of the two devices. The coordination system then determines which SMEMA signal has to be sent to the other of the two devices in order to optimize the production process. The emulator can moreover forward control signals which fall outside the SMEMA standard to for instance other inputs of the (adjoining) device in order to optimize the production process. The SMEMA circuits on board the devices need not be adjusted for this purpose.

The manner in which the throughput times per machine in the production line can be tracked is also described. In an example with three devices, a first device, a second device and a third device, the throughput time of the second device is measured. During an equipping process a board is transferred from the first device to the second device and from the second device to the third device. On the SMEMA interface between the first device and the second device a product available signal is generated by the first device and a machine available signal by the second device (the downstream device). The chronology of the two signals is not fixed beforehand. When the two signals have been generated (have the value "true"), a board is transferred from the first device to the second device. The moment at which the machine available signal obtains the value "false" after the two signals have first obtained the value "true" is regarded as a starting point of a processing cycle of the second device. By arranging a first SMEMA emulator in this SMEMA interface this starting point is tracked by a coordination circuit.

A SMEMA interface is present between the second device and the third device. A second SMEMA emulator is arranged in this SMEMA interface. This also forwards the product available signal from the second device to the coordination circuit. The product available signal from the second device, which is identified as the product which was previously transferred between the first device and the second device, is regarded as the end point of the processing cycle of the second device. Because both the starting point and the end point relate to the same product, the time difference between the end point and the starting point of the processing cycle is the so-called processing time of the second device.

Processing steps at other locations in the production line are planned on the basis of the processing time.

This method is used to collect throughput times of machines when these machines cannot report this in other manner. Processing steps are optionally planned at other locations in the line on the basis thereof. This optimization is however only available for processing steps which can take place at multiple locations in the line.

US6618935 describes a method for equipping substrates with components using a production line with devices. Each device has a control system connected to a central system for the production line.
It is assumed that determined operations can be performed at multiple positions in a device (for instance by different heads) or by a plurality of devices. On the basis of an initial model the operations are allocated such that the capacity of the production line is optimal. The model thus results in a prediction of the performance of the line and the different devices in the production line. The performance is expressed in capacity (such as components per hour) and the capacity is inversely proportional to the throughput time. The production line is controlled in accordance with the optimal capacity according to the model. An adjusted model is made on the basis of a current measurement of the throughput time of machines in the production line, which can differ structurally or incidentally from the prediction. Using this adjusted model, processing steps are for instance reallocated from the one machine to another location in the same machine (for instance when a machine has a plurality of heads) or even to another machine. The production line is then used as according to this adjusted model.
The capacity of the production line is optimized by processing the current behaviour of a machine via modeling of variances of the initial model. The model itself optimizes the production line, wherein bottlenecks in the capacity are thus avoided on the basis of predictions. This optimization is however only available for processing steps which can take place at multiple locations in the production line, i.e. for devices in the production line which can perform the same function.

Despite the production line being optimized hereby in respect of a number of devices in the production line, there is a need for an analysis system for analyzing the current performance of a production line which can increase the performance of a production line further still.

The technical problem which the invention seeks to at least partially solve is to provide a method for analyzing performance of a production line provided with a number of devices, including a first device and a second device placed downstream thereof, and provided with a SMEMA interface between the first device and the second device.

The object of the invention is achieved in that the invention provides a method according to claim 1.

As the skilled person will appreciate, the available signals on the SMEMA interface (i.e. the product available signal and the machine available signal) will occur in a chronological order not known beforehand.

Because the available signal from the first device and the available signal from the second device are received in an analyser via the tap module, the time difference in duration of the pair of available signals can be measured with an evaluation unit of the analyser. Because said available signals overlap in time, they are signals relating to the transfer of one and the same product from the first device to the second device. Because it is laid down in the SMEMA standard that the upstream device produces a product available signal and the downstream device a machine available signal, which are generated on different conductors in a SMEMA interface, the source device which was the source of the available signal with the latest starting moment can then be determined. This is possible by determining that the first device is the source device if the product available signal was last to start, and by determining that the second device is the source device if the machine available signal was last to start.

The extent to which the source device limits performance in the production line is quantitatively analyzed by assigning the time difference to the source device.

Because the first device and the second device need not be able to perform the same task but can for instance be a screen printer and a pick and place machine, the method can be advantageously applied to analyze performance of a production line, wherein it is not necessary that processing steps can take place at multiple locations in the production line.

SMEMA interfaces are frequently used and are well-defined. Because the available signals are tapped from the SMEMA interface, use can be made of the well-defined occurrence of the product available signal and the machine available signal. The results of the analysis will hereby also be very useful.

Because of the tapping from the SMEMA interface the method can moreover be applied in an existing line with devices provided with SMEMA connections, and no adjustments to the first device and the second device are necessary so as to be able to perform the analysis.

Measuring the time difference in duration of the pair of available signals comprises of measuring a voltage on two conductors in the SMEMA interface. This measuring of the voltage can take the form of detecting a high/low transition and storing a timestamp in a register or measuring a time at which a voltage is equal to a reference voltage.

When measuring the high/low transition on a conductor of the two conductors, the voltage on this conductor is compared by the analyser to the voltage on a further conductor (not forming part of the two conductors) of the SMEMA interface. When an available signal is generated on the conductor, the conductor and the further conductor are short-circuited, whereby the voltage is equalized. When no available signal is generated, the conductor and the further conductor are at different voltages.

An embodiment of the invention is provided by the method according to claim 2.

By comparing the duration of a first available signal to a reference duration the time difference is also determined. This is efficient since the time difference can be used in step (e).

An embodiment of the invention is provided by the method according to claim 3.

When the transport time is used, the transport time is corrected for at the same time.

When the second available signal is used, steps (c) and (d) can be combined, which makes the method more efficient.

An embodiment of the invention is provided by the method according to claim 4.

By measuring the time difference between the first receiving moment (the moment at which the first received available signal is received) and the final starting moment using the analyser and assigning it to the source device, the extent to which the source device limits performance in the production line is quantitatively analyzed.

An embodiment of the invention is provided by the method according to claim 5.

By measuring the duration of the first received available signal and correcting it for a transport time, it is possible to determine the duration without directly comparing the starting times of the available signals of the first device and the second device. It is hereby possible to work with very rapid switching, which is advantageous in view of the high speeds applied in production lines.

During transport of a product from the first device to the second device there is a period in which the production operations of the first device and the second device are impeded. This embodiment is advantageous if it is assumed that the transport time is fixed. The duration is therefore corrected herefor, so that the corrected duration comprises information which is most relevant.

In an advantageous embodiment the ratio of the time difference and a time between the start of the available signal from the source device and a subsequent available signal from the source device is calculated.

By calculating this ratio the extent of the impact of the time difference on the performance of the source machine can be made clear to a user.

An embodiment of the invention is provided by the method according to claim 6.

If it is determined that the second device is the source device, but the second device itself cannot deliver products on a downstream side thereof, the second device therefore cannot accept products from the first device. This embodiment prevents the time difference being wrongfully assigned to the second device.

An available signal from a SMEMA output of the second device is received for this purpose by the analyser for performing a correction.

Performing the correction can consist of subtracting the value with a microprocessor.

The reception by the analyser is for instance possible by directly connecting the analyser to the SMEMA output of the second device or by tapping a SMEMA interface at the SMEMA output of the second device.

An embodiment of the invention is provided by the method according to claim 7.

If it is determined that the first device is the source device, but the first device itself awaits products on the upstream side, this is the reason the second device cannot accept products from the first device. This embodiment prevents the time difference being wrongfully assigned to the first device.

An available signal from a SMEMA input of the first device is received for this purpose by the analyser for performing a correction.

Performing the correction can consist of subtracting the value with a microprocessor.

The reception by the analyser is for instance possible by directly connecting the analyser to the SMEMA input of the first device or by tapping a SMEMA interface at the SMEMA input of the first device.

In an embodiment of the method according to any of the claims 1-7 the assigning of the time difference comprises of storing the time difference in a memory device.

In an embodiment of the method according to any of the claims 1-7 the steps (b)-(d) of the method are implemented in a computer.

The technical problem which the invention seeks to at least partially solve is to provide an analysis system for analyzing performance of a production line provided with a number of devices, including a first device and a second device placed downstream thereof, and provided with a SMEMA interface between the first device and the second device.

The object of the invention is achieved in that the invention provides an analysis system according to claim 8.

As the skilled person will appreciate, the available signals on the SMEMA interface (i.e. the product available signal and the machine available signal) will occur in a chronological order not known beforehand.

Because the analyser is configured to receive the available signal from the first device (3) and the available signal from the second device (4) via the tap module and is provided with an evaluation unit, the time difference in duration of the pair of available signals can be measured with the evaluation unit of the analyser. Because said available signals overlap in time, they are signals relating to the transfer of one and the same product from the first device to the second device. Because it is laid down in the SMEMA standard that the upstream device produces a product available signal and the downstream device a machine available signal, which are generated on different conductors in a SMEMA interface, the analysis system can be used to subsequently determine the source device which was the source of the available signal with the latest starting moment. This is possible by determining that the first device is the source device if the product available signal was last to start, and by determining that the second device is the source device if the machine available signal was last to start.

The extent to which the source device limits performance in the production line is quantitatively analyzed in that the analyser assigns the time difference to the source device.

Because the first device and the second device need not be able to perform the same task but can for instance be a screen printer and a pick and place machine, the use of the analysis system is advantageous for analyzing performance of a production line, wherein it is not necessary that processing steps can take place at multiple locations in the production line.

SMEMA interfaces are frequently used and are well-defined. Because the product available signal and the machine available signal are tapped from the SMEMA interface with the tap module, use can be made of the well-defined occurrence of the product available signal and the machine available signal. The results of an analysis performed with the analysis system will hereby also be very useful.

Due to the presence of the tap module the analysis system can moreover be applied in an existing line with devices provided with SMEMA connections, and no adjustments to the first device and the second device are necessary so as to be able to use the analysis system.

The analyser is configured to measure the time difference in duration of the pair of available signals in that it is configured to measure a voltage on two conductors in the SMEMA interface. The analyser is for instance configured here to detect a high/low transition and to store a timestamp in a register or to measure a time at which a voltage is equal to a reference voltage.

When measuring the high/low transition on a conductor of the two conductors, the voltage on this conductor is compared by the analyser to the voltage on a further conductor (not forming part of the two conductors) of the SMEMA interface. When an available signal is generated on the conductor, the conductor and the further conductor are short-circuited, whereby the voltage is equalized. When no available signal is generated, the conductor and the further conductor are at different voltages.

In an embodiment the assigning unit is configured to store the time difference in a memory device.

An embodiment of the invention is provided by the analysis system according to claim 9.

By comparing the duration of a first available signal to a reference duration the time difference is also determined. This is efficient since the time difference can be used for assigning to the source device.

In use the reference duration can be a transport time or the duration of a second available signal of the pair of available signals.

An embodiment of the invention is provided by the analysis system according to claim 10.
Because the analyser is configured to measure a time difference between a first starting moment of the first received available signal and the final starting moment and is configured to assign it to the source device, the analysis system can be used for quantitative analysis of the extent to which the source device limits performance in the production line.

An embodiment of the invention is provided by the analysis system according to claim 11.

By measuring the duration of the first received available signal and correcting it for a transport time, it is possible to determine the duration without directly comparing the starting times of the available signals of the first device and the second device. It is hereby possible to work with very rapid switching, which is advantageous in view of the high speeds applied in production lines.

During transport of a product from the first device to the second device there is a period in which the production operations of the first device and the second device are impeded. This embodiment is advantageous if it is assumed that the transport time is fixed. The duration is therefore corrected herefor, so that the corrected duration comprises information which is most relevant.

In an advantageous embodiment the analyser is configured to calculate the ratio of the time difference and a time between the start of the available signal from the source device and a subsequent available signal from the source device.

Because the analyser is configured to calculate this ratio, the significance of the time difference to the performance of the source machine will be calculated.

An embodiment of the invention is provided by the analysis system according to claim 12.

If it is determined that the second device is the source device, but the second device itself cannot deliver products on a downstream side thereof, the second device therefore cannot accept products from the first device. An analysis system according to this embodiment prevents the time difference being wrongfully assigned to the second device.

The analyser is configured for this purpose to receive an available signal from a SMEMA output of the second device for performing a correction.

Performing the correction can consist of subtracting the value with a microprocessor.

The reception by the analyser is for instance possible by directly connecting the analyser to the SMEMA output of the second device or by tapping a SMEMA interface at the SMEMA output of the second device.

An embodiment of the invention is provided by the analysis system according to claim 13.

If it is determined that the first device is the source device, but the first device itself awaits products on the upstream side thereof, the second device therefore cannot accept products from the first device.

An analysis system according to this embodiment prevents the time difference being wrongfully assigned to the first device.

The analyser is configured for this purpose to receive an available signal from a SMEMA input of the first device for performing a correction.

Performing the correction can consist of subtracting the value with a microprocessor.

The reception by the analyser is for instance possible by directly connecting the analyser to the SMEMA input of the first device or by tapping a SMEMA interface at the SMEMA input of the first device.

Examples of embodiments of the invention will be described hereinbelow using the accompanying schematic figures. Corresponding components are designated in the figures with corresponding reference symbols. The components are not necessarily provided with a reference symbol in all figures. The schematic figures are not necessarily to scale and some features may be exaggerated in order to better illustrate and elucidate the invention.

SMEMA interfaces and inputs and outputs are known from Interface Standard 1.2 of the Surface Mount Equipment Manufacturers Association and the IPC-SMEMA-9851, Mechanical Equipment Interface Standard.

A SMEMA input is here a port whereby a device can form a SMEMA interface with a device situated upstream thereof.

A SMEMA output is here a port whereby a device can form a SMEMA interface with a device situated downstream thereof.

The examples do not attempt to provide an exhaustive list of examples or to otherwise limit the invention to the precise configurations as shown in the figures or described in the following detailed description.

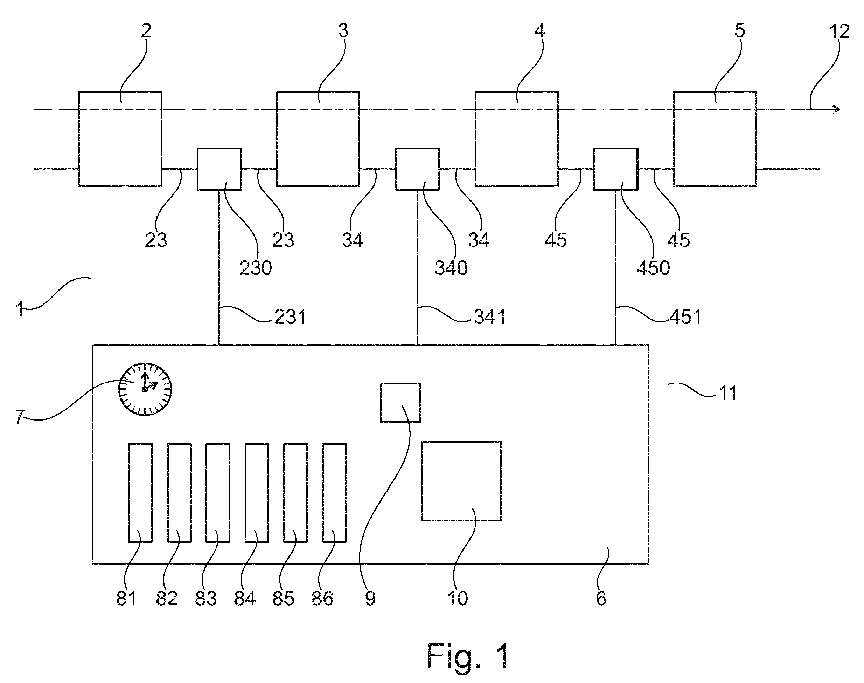

Figure 1 shows a schematic representation of the analysis system according to the invention.

Figure 1 shows schematically a production line (1) with four devices (2,3,4,5). The devices (2,3,4,5) can for instance comprise a screen printer, a pick and place machine for SMDs, a reflow oven and an inspection station. A product which is produced on the production line (1) moves to the right in the diagram. The product thus comes to the first device (3) before the second device (4). It subsequently comes to a further device (4). Even before the product comes to the first device (3) the product has however already come to an additional device (2). The product hereby runs through a production process (12).

A number of SMEMA interfaces is present between the four devices (2,3,4,5). A SMEMA interface (34) is present between a SMEMA output of the first device (3) and a SMEMA input of the second device (4). A further SMEMA interface (45) is present between a SMEMA output of the second device (4) and a SMEMA input of the further device (5). An additional SMEMA interface (23) is present between a SMEMA output of the additional device (2) and a SMEMA input of the first device (3).

A tap module (340) is placed in the SMEMA interface (34). A further tap module (450) is placed in the further SMEMA interface (45). An additional tap module (230) is placed in the additional SMEMA interface (23).

The tap module (340) is connected via a signal cable (341) to an analyser (6), which is thereby able to receive available signals, i.e. product available signals and machine available signals.

The further tap module (450) is connected via a further signal cable (451) to the analyser (6), which is thereby able to receive further product available signals from the second device and further machine available signals from the further device.

The additional tap module (230) is connected via an additional signal cable (231) to the analyser (6), which is thereby able to receive additional product available signals from the additional device and additional machine available signals from the first device.

On a random SMEMA interface product available signals and machine available signals are further not provided with a timestamp.

The available signals have a starting moment here, and the available signals are each time generated for a period of time, as is usual in SMEMA interfaces. In this example a contact is made between two conductors of a SMEMA interface for the purpose of generating an available signal.

The analyser (6), the tap module (340), the signal cable (341), the further tap module (450), the further signal cable (451), the additional tap module (230) and the additional signal cable (231) together form an analysis system (11).

The analyser (6) is provided with a clock (7) and a number of registers (81,82,83,84,85,86). When one of the stated signals is received, it is recorded in a register together with starting and end moment of reception. The analyser registers the product available signals and corresponding starting and end moments of reception in a first register (81), the machine available signals and corresponding starting and end moments in a second register (82), the further product available signals and corresponding starting and end moments in a third register (83), the further machine available signals and corresponding starting and end moments in a fourth register (84), the additional product available signals and corresponding starting and end moments in a fifth register (85) and the additional machine available signals and corresponding starting and end moments in a sixth register (86).

The analyser (6) is provided with a microprocessor (9) which can write to and read the registers (81,82,83,84,85,86). The microprocessor (9) and the registers (81,82,83,84,85,86) thereby together form an evaluation unit (9, 81,82,83,84,85,86) and an assigning unit (9, 81,82,83,84,85,86) within the analyser.

By subtracting the corresponding receiving times in the second register (82) and the first register (81) from each other using the microprocessor (9), the analyser (6) can determine the time difference between the starting moments of reception of a machine available signal and a product available signal on the SMEMA interface between the first device and the second device. Using the microprocessor (9) of the evaluation unit the analyser (6) can moreover determine which of the corresponding receiving times came later by subtracting them from each other and determining whether the remainder is positive or negative.

In this example the device subtracts the starting moment of the machine available signal from the starting moment of the product available signal which overlaps in time with the machine available signal. The machine available signal and product available signal overlapping therewith in time together form a pair of available signals. The sign (positive or negative) of the outcome is compared in the evaluation unit to the value positive (this corresponds to the product available signal coming later in a reference situation). The machine available signal and the product available signal end at the same time. The time difference is thereby also the difference in duration of the machine available signal and the product available signal. If the outcome of the comparison is positive, the microprocessor (9) assigns the time difference to the first device (30). If the outcome of the comparison is negative, the microprocessor (9) assigns the time difference to the second device (4). The negative sign is of course taken into consideration during the assigning.

During the assigning the assigning unit of the analyser stores the time difference in an output register (10). The content of the output register (10) is shown to a user via a monitor, optionally after checking whether corrections are necessary and then, if this is the case, performing corrections.

The analysis system is further configured to use the microprocessor (9) when assigning the time difference to the second device (4) in order to determine whether there is a period in which there is a further product available signal on a further SMEMA interface (45), while this period also has a period of overlap with the time interval between receiving the first starting moment and the final starting moment. This is done by reading the third register (83). The duration of the period of overlap is then determined. The duration of the period of overlap is subtracted from the time difference which is assigned to the second device (4) in order to correct the time difference.

The analysis system is further configured to use the microprocessor (9) when assigning the time difference to the first device (3) in order to determine whether there is an additional period in which there is an additional machine available signal, while this period also has an additional period of overlap with the time interval. This is done by reading the fifth register (85).
The duration of the additional period of overlap is then determined. The duration of the additional period of overlap is subtracted from the time difference which is assigned to the first device in order to correct the time difference.

In a variant the tap modules of the SMEMA interface, the further SMEMA interface and the additional SMEMA interface are connected via a collecting unit to the analyser. In yet another variant the signals on the three SMEMA interfaces are converted in the three tap modules into a signal which is transported to the analyser on a shared connection, such as a UTP connection. The three connections between the tap modules and the analyser can also run wirelessly. In a variant the three tap modules are each provided with a clock and the three tap modules also transmit a timestamp with the relevant product available and machine available signals which are forwarded to the analyser.

In a number of variants of this example the time difference in duration of the pair of available signals is measured in other manner. It is assumed here that the pair of available signals ends at the same time.

In a first variant the source device is determined by subtracting a reference duration from the duration of a first available signal of the pair of available signals, after which a remainder remains. The first available signal can be a random available signal of the pair of available signals.

The reference duration is equal to a transport time. This transport time is for instance determined during the adjustment of the analysis system. The whole production line is emptied here. Only one product is then carried through the line. The duration of the transport time is measured in each SMEMA interface by measuring how long the product available signal and the machine available signal on this SMEMA interface overlap. In the case of the SMEMA interface (34) between the first device (3) and the second device (4) this time corresponds to the minimum time necessary to transport the product from the first device (3) to the second device (4).

If the available signal is found to be shorter than the reference duration, the device which transmitted the first available signal is the source device. The device which transmitted the first available signal is also the source device if the duration of the first available signal is equal to the reference duration. The assigning then results in the assigning of a time difference 0, so that this is without further consequence.

In the first variant the remainder is assigned to the source device as time difference.

In a second variant the reference time is the duration of the second available signal of the pair of available signals. Since it is assumed that the pair of available signals ends at the same time, the difference in duration is equal to the time difference which can be assigned to the source device.

Some aspects of the invention can be embodied in a computer program product, i.e. in a set of computer program instructions stored on a storage device which is readable by a computer and executable by a computer. The instructions of the present invention can be incorporated into any interpretable or executable code mechanism, including but not limited to scripts, interpretable programs, dynamic link libraries (DLLS) or Java classes. The instructions can form a fully executable program or changes to an existing program or add-ons (plug-ins) for an existing program. Parts of the processing of the present invention can moreover be distributed over different computers or processors for a better performance, reliability or cost.

Storage devices suitable for storing computer program instructions comprise all forms of non-volatile memory, including for instance memory devices based on semiconductors (e.g. EPROM, EEPROM and flash memory), magnetic discs such as internal and external hard discs and removable discs, magneto-optical discs and CD-ROM discs. The computer program product can be distributed on such a storage device or can be offered for download via HTTP, FTP or a similar mechanism, wherein a server is connected to a network such as the internet. Transfer of the computer program product via e-mail is of course also possible.

## Claims

1. Method for analysing performance of a production line provided with a number of devices, including a first device and a second device placed downstream thereof, and provided with a SMEMA interface between the first device and the second device; with the steps of:
- (a) tapping available signals from the SMEMA interface using a tap module; and
- (b) receiving a pair of available signals from the tap module using an analyser, comprising an available signal from the first device and an available signal from the second device overlapping in time with the available signal from the first device;
**characterized by** the steps of:
- (c) measuring the time difference in duration of the pair of available signals using the analyser;
- (d) determining a source device corresponding to the final starting moment of the pair of available signals;
- (e) assigning the time difference to the source device using an assigning unit.

2. Method as claimed in claim 1, wherein step (d) comprises of:
- comparing the duration of a first available signal of the pair of available signals to a reference duration using an evaluation unit of the analyser and determining a source device corresponding to a duration of the first available signal, having a maximum duration equal to the reference duration, wherein the reference duration corresponds to a transport time or the duration of a second available signal of the pair of available signals.

3. Method as claimed in claim 2, wherein the reference duration is a transport time or the duration of a second available signal of the pair of available signals.

4. Method as claimed in claim 1, 2 or 3, wherein step (c) comprises of measuring a time difference between a first starting moment of the first received available signal and the final starting moment using the analyser.

5. Method as claimed in claim 1, 2 or 3, wherein the analyser measures the time difference by measuring the duration of the first received available signal and correcting it for a transport time.

6. Method as claimed in any of the foregoing claims, wherein the SMEMA interface runs between a SMEMA output of the first device and a SMEMA input of the second device; provided with the steps of:
- receiving an available signal from a SMEMA output of the second device using the analyser;
- determining a period of overlap in which an available signal is received from the SMEMA output of the second device and a time interval between receiving the first starting moment and the final starting moment;
- correcting the time difference which is assigned to the second device with the duration of the period of overlap.

7. Method as claimed in any of the foregoing claims, wherein the SMEMA interface runs between a SMEMA output of the first device and a SMEMA input of the second device; provided with the steps of:
- receiving an available signal from a SMEMA input of the first device using the analyser;
- determining an additional period of overlap in which an available signal is received from the SMEMA input of the first device and a time interval between receiving the first starting moment and the final starting moment;
- correcting the time difference which is assigned to the first device with the duration of the additional period of overlap.

8. Analysis system for analyzing performance of a production line provided with a number of devices, including a first device and a second device placed downstream thereof, and provided with a SMEMA interface between the first device and the second device, wherein the analysis system is provided with:
- a tap module configured to tap available signals from the SMEMA interface;
- an analyser configured to receive a pair of available signals, comprising an available signal from the first device and an available signal from the second device overlapping in time with the available signal from the first device;
**characterized in that**
- the analyser is configured to measure the time difference in duration of the pair of available signals;
- the analyser is configured to determine a source device corresponding to the final starting moment of the pair of available signals;
- the analyser is provided with an assigning unit for assigning the time difference to the source device.

9. Analysis system as claimed in claim 8, provided with an evaluation unit for comparing the duration of a first available signal of the pair of available signals to a reference duration and determining a source device corresponding to a duration of the first available signal, having a maximum duration equal to the reference duration.

10. Analysis system as claimed in claim 9, wherein
- the analyser is configured to measure a time difference between a first starting moment of the first received available signal and the final starting moment.

11. Analyser as claimed in claim 8, 9 or 10, wherein the analyser is configured to measure the time difference by measuring the duration of the first received available signal and correcting the duration for a transport time.

12. Analyser as claimed in claim 8, 9, 10 or 11, wherein
- the analyser is configured to receive an available signal from a SMEMA output of the second device;
- the analyser is configured to determine a period of overlap in which an available signal is received from the SMEMA output of the second device and a time interval between receiving the first starting moment and the final starting moment;
- the analyser is provided with means for correcting the time difference which is assigned to the second device with the duration of the period of overlap.

13. Analyser as claimed in claim 8, 9, 10, 11 or 12, wherein
- the analyser is configured to receive an available signal from a SMEMA input of the first device;
- the analyser is configured to determine an additional period of overlap in which an available signal is received from the SMEMA input of the first device and a time interval between receiving the first starting moment and the final starting moment;
- the analyser is provided with means for correcting the time difference which is assigned to the second device with the duration of the additional period of overlap.
